# EUROPÄISCHE PATENTANMELDUNG

(11) **EP 1 091 421 A2**
(43) Veröffentlichungstag der Anmeldung: **11.04.2001**
(21) Anmeldenummer: 00120897.4
(22) Anmeldetag: 26.09.2000
(51) Int. Cl.: H01L 31/108

(54) **Verfahren zur Umwandlung von Lichtpulsen in elektrische Signale**

(30) Priorität: 07.10.1999 DE 19948415
(71) Anmelder: FORSCHUNGSZENTRUM JÜLICH GMBH, 52425 Jülich (DE)
(72) Erfinder: Buchal, Christoph, Prof. Dr., 52428 Jülich (DE); Löken, Michael, Dr., 52428 Jülich (DE)
(74) Vertreter: Paul, Dieter-Alfred, Dipl.-Ing.

(57) **Zusammenfassung**

Die Erfindung beschreibt ein Verfahren zur Umwandlung von Lichtpulsen in elektrische Signale mittels einer Metall-Halbleiter-Metall-Photodiode (1), bei dem die Photodiode (1) mit Lichtpulsen beleuchtet wird und die Lichtpulse von der Photodiode (1) in elektrische Signale umgesetzt werden, die dadurch gekennzeichnet ist, daß die Photodiode (1) mit Lichtpulsen von einer solchen Wellenlänge beleuchtet wird, daß heiße Ladungsträger aus einer Metallschicht (3) der Photodiode (1) in den Halbleiter (2) emittiert werden und in dem Halbleiter (2) relaxieren, wobei die Relaxation einen Verschiebungsstrom induziert, der sich als elektrischer Puls manifestiert.

## Beschreibung

Die vorliegende Erfindung betrifft ein Verfahren zur Umwandlung von Lichtpulsen in elektrische Signale mittels einer Metall-Halbleiter-Metall-Photodiode, bei dem die Photodiode mit Lichtpulsen beleuchtet wird und die Lichtpulse von der Photodiode in elektrische Signale umgesetzt werden.

Die moderne Optokommunikation mit ihren hohen Übertragungsbandbreiten macht die Entwicklung von immer schnelleren Bauelementen zur Informationsverarbeitung erforderlich. Die Information, die mittels Lichtpulsen in Glasfaserkabeln übertragen wird, muß zur Signalverarbeitung in elektrische Signale umgewandelt werden. Dies geschieht mit schnellen Photodioden, deren elektrischer Widerstand sich bei Einstrahlung von Licht ändert. Wird eine elektrisch vorgespannte Photodiode mit einem kurzen Lichtpuls beleuchtet, so wird ein Spannungspuls erzeugt, der mit einer nachgeschalteten Elektronik weiterverarbeitet werden kann. Es ist aus MRS Bulletin/April 1998, Seiten 55 bis 59 bekannt, als Photodetektoren sogenannte MSM-(metal-semiconductor-metal)Dioden mit einem möglichst geringen Elektrodenabstand zu verwenden. Diese MSM-Dioden besitzen ein Substrat aus beispielsweise Silizium, auf dem zwei metallisch leitende Schichten zur Bildung zweier Elektroden vorgesehen sind. An diese Elektroden wird eine Spannung angelegt, um in dem Halbleiter ein möglichst hohes elektrisches Feld zu erzeugen. Wenn die Photodiode jetzt beleuchtet wird, werden die Lichtquanten (Photonen) in der halbleitenden Schicht absorbiert und erzeugen im Halbleiter Ladungsträger, d.h. Elektroden und Löcher, wobei die Elektronen im Leitungsband und die Löcher im Valenzband entstehen. Durch das elektrische Feld werden die Elektronen zur positiv gepolten Elektrode und die Löcher zur negativ gepolten Elektrode beschleunigt. Eine entscheidende Zeitkonstante der Anordnung ergibt sich durch die Länge der Driftwege der Ladungsträger. Selbst wenn die Spannung zwischen den Elektroden ausreicht, um die Sättigungsdriftgeschwindigkeit der Ladungsträger zu erzielen, benötigen Elektronen und Löcher typischerweise mindestens 10 ps, um den Weg von 1 µm zurückzulegen. Aus diesem Grund werden sehr schnelle MSM-Detektoren derart gebaut, daß der Abstand der Elektroden möglichst gering ist und die Kontaktgeometrie ein möglichst hohes und homogenes elektrisches Feld ergibt. Beispielsweise wird in der oben genannten Publikation vorgeschlagen, die Elektroden planar als ineinandergreifende Fingerstrukturen auszuführen. Hierdurch werden kurze Elektrodenabstände erreicht. Nachteilig bei solchen Dioden ist jedoch, daß wegen der lithographischen Auflösung der Verringerung der Fingerabstände Grenzen gesetzt und insofern auch die erreichbaren Schaltzeiten begrenzt sind.

Aufgabe der Erfindung ist es daher, ein Verfahren zur Umwandlung von Lichtpulsen in elektrische Signale der eingangs genannten Art anzugeben, das sehr kurze Schaltzeiten ermöglicht.

Diese Aufgabe ist bei dem eingangs genannten Verfahren dadurch gelöst, daß die Photodiode mit Lichtpulsen von einer solchen Wellenlänge beleuchtet wird, daß Ladungsträger aus einer Metallschicht der Photodiode in den Halbleiter emittiert werden und in dem Halbleiter relaxieren, wobei die Relaxation einen Verschiebungsstrom induziert, der sich als elektrischer Puls manifestiert. Der Erfindung liegt somit die Überlegung zugrunde, die Relaxation der Ladungsträger, die insbesondere durch Stöße an optischen Photonen erfolgt, auszunutzen, um einen schnell abklingenden Verschiebungsstrom an den beiden Elektroden zu induzieren. Es hat sich herausgestellt, daß auf diese Weise deutlich bessere Schaltzeiten erreichbar sind als im Stand der Technik, wo das Dritten der Ladungsträger zu den Elektroden ausgenutzt wurde.

Im Falle der Verwendung von MSM-Elektroden mit Schottky-Kontakten wird ein Relaxieren der Ladungsträger erreicht, indem die Wellenlänge der Lichtpulse so gewählt wird, daß die Energiequanten der Photonen größer als der Wert der Schottky-Barriere, aber kleiner als die Bandlückeneregie des Halbleiters sind. Dabei werden durch die Lichtabsorption heiße Ladungsträger in einer oder beiden Metallelektroden erzeugt, wobei ein gewisser Bruchteil dieser heißen Ladungsträger über die Schottky-Barriere in den Halbleiter emittiert (innerer Photoeffekt). Diese finden im Halbleiter Potentialverhältnisse vor, die keine kräftige Beschleunigung und damit eine Drift zu den gegenüberliegenden Elektroden, jedoch eine Relaxation der Ladungsträger bewirken, um einen schnell abklingenden Verschiebungsstrom an den beiden Elektroden zu induzieren.

In vorteilhafter Weise sind die Schottky-Barrieren unsymmetrisch derart, daß die Schottky-Barriere an dem ersten Schottky-Kontakt für Löcher geringer ist als die Barriere für Elektronen und an dem zweiten Schottky-Kontakt die Schottky-Barriere für Elektroden geringer ist als die für Löcher. Auf diese Weise wird erreicht, daß sowohl für Löcher als auch für Elektronen der Relaxationsprozeß das optische Signal dominiert, so daß beide Arten von Ladungsträgern nicht bis zur gegenüberliegenden Elektrode driften. Die erfindungsgemäße Ladungsträgerdynamik im Halbleiter bewirkt, daß die beobachteten Signale noch wesentlich schneller sind als bei einer MSM-Anordnung in konventioneller Betriebsart, selbst bei sehr kleinen Elektrodenabständen. Der generierte verschiebungsstrom ergibt nach dem Schottky-Ramos-Theorem einen bipolaren Puls, wobei allerdings die erste ansteigende und abfallende Flanke, bedingt durch den Relaxationsprozeß, wesentlich schneller verläuft als der Diffusionsprozeß zurück zur Ausgangselektrode.

Es ist darauf hinzuweisen, daß die jeweils niedrigere Schottky-Barriere die Photoemission der Ladungsträger dominieren wird. Durch die Wahl unterschiedlicher Metall-Halbleiter-Kombinationen kann man die Höhe der Schottky-Barrieren einstellen. Im übrigen kann an der Photodiode eine Spannung angelegt werden, die einem Driften von Ladungsträgern zwischen den Metallschichten entgegenwirkt.

Hinsichtlich weiterer vorteilhafter Ausgestaltungen der Erfindung wird auf die Unteransprüche sowie die nachfolgende Beschreibung eines Ausführungsbeispiels unter Bezugnahme auf die beiliegende Zeichnung verwiesen. In der Zeichnung zeigt
- Figur 1: eine MSM-Photodiode mit planarer Struktur zur Durchführung des erfindungsgemäßen Verfahrens,
- Figur 2: eine MSM-Photodiode mit Graben-Struktur zur Durchführung des erfindungsgemäßen Verfahrens,
- Figur 3: den Bandverlauf in einer dünnen Siliziumschicht zwischen zwei Metallschichten einer MSM-Photodiode, und
- Figuren 4a und 4b: Diagramme, die das Pulsantwortverhalten einer Ti-Si-CoSi₂-Photodiode unter Anwendung eines herkömmlichen Verfahrens und des erfindungsgemäßen Verfahrens darstellen.

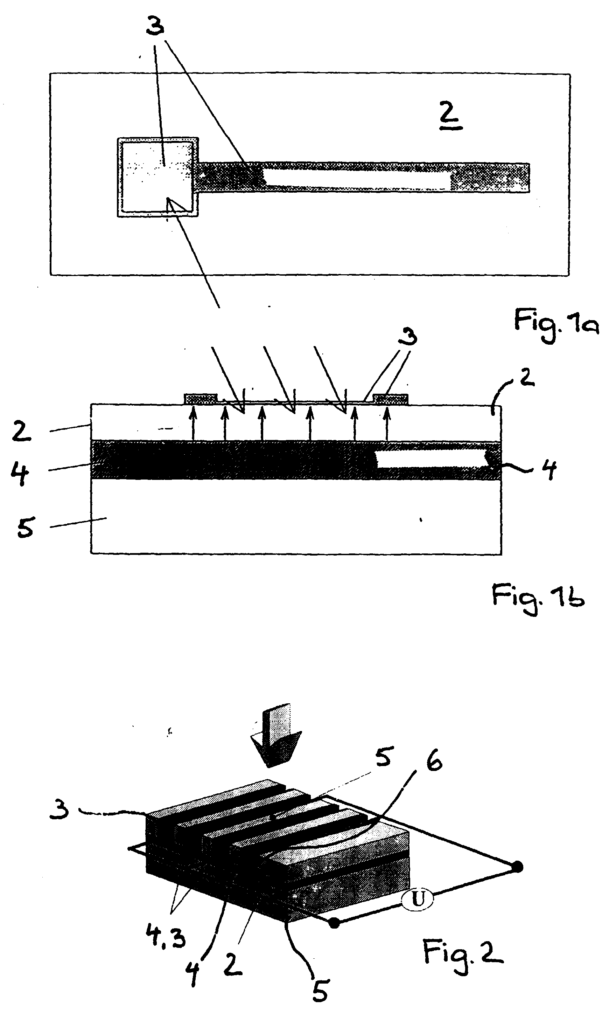

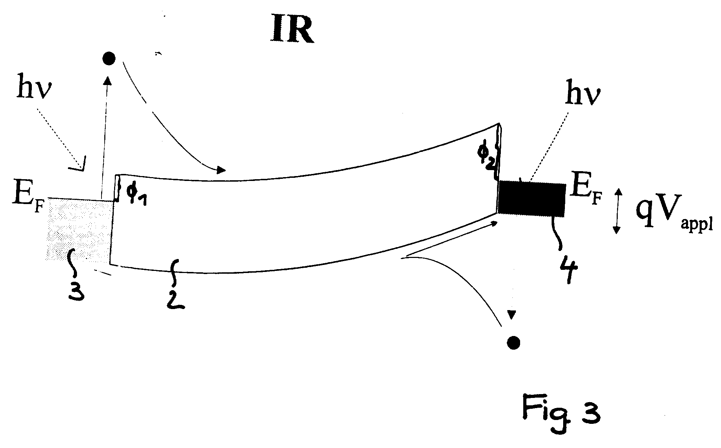

In den Figuren 1 und 2 sind zwei Ausführungsformen von Photodioden 1 dargestellt, die mit einer Metall-Halbleiter-Metall-Struktur aufgebaut und an sich bereits bekannt sind. Die in Figur 1 dargestellte Photodiode 1 mit einer planaren Struktur besitzt ein Halbleitersubstrat 2, auf dem zwei metallisch leitende Schichten 3, 4 zur Bildung zweier Elektroden, zwischen denen eine Spannung anlegbar ist, vorgesehen sind. Die Elektroden 3, 4 sind hier planar als ineinandergreifende Fingerstrukturen ausgeführt.

Die in Figur 2 dargestellte Photodiode 1 ist in an sich ebenfalls bekannter Weise mit einer Graben-Struktur auf einem SOI(silicium-on-insulator)-Substrat versehen. Im einzelnen besitzt die Photodiode 1 ein Substrat 5 aus einem isolierenden Material, in dem eine Halbleiterschicht 2 vorgesehen ist. In das Substratmaterial oberhalb der Halbleiterschicht 2 sind Gräben 6 eingearbeitet, in welche Metallelektroden 3, 4 so eingesetzt sind, daß sie die Haolbleiterschicht 2 flächig kontaktieren, wobei nebeneinanderliegende Metallelektroden 3, 4 jeweils unterschiedliche Polarität besitzen und eine Spannung zwischen den Elektroden 3, 4 anlegbar ist.

Weitere Arten von MSM-Detektoren sind beispielsweise aus der eingangs genannten Publikation MRS Bulletin/April 1998 bekannt, auf die insofern inhaltlich Bezug genommen wird.

Erfindungsgemäß werden die Photodioden 1, wie sie beispielhaft in den Figuren 1 und 2 dargestellt sind, mit Lichtpulsen beleuchtet. Die Wellenlänge der Lichtpulse ist dabei jeweils so gewählt, daß die einfallenden Photonen nicht in der Lage sind, Elektronen-Paare in dem Halbleitermaterial, hier Silizium, zu erzeugen, es wohl aber möglich ist, mit Hilfe des internen Photoeffekts bei wenigstens einer der Metallelektroden Elektronen über die Schottky-Barriere φ anzuregen. Dies wird erreicht, indem Licht mit einer solchen Wellenlänge verwendet wird, daß die Energiequanten hν der Photonen größer als der Wert der Schottky-Barriere φ, aber kleiner als die Bandlückenenergie des Halbleiters 2 ist. So wird beispielsweise bei einem Silizium-Halbleiter mit einer Bandlücke von etwa 1,1 eV die Wellenlänge der Lichtpulse so gewählt, daß die Quantenenergie der Photonen in Abhängigkeit von der zu überwindenden Schottky-Barriere φ, die je nach Wahl der Materialien etwa zwischen 0,3 bis 0,7 Elektronenvolt liegen, größer als diese Schottky-Barriere und kleiner als 1,1 eV ist. In der Regel dürfte es sich um um Licht im infraroten Bereich handeln.

Da an der Photodiode 1 keine oder nur eine sehr geringe Spannung anliegt, finden die über die Schottky-Barriere emittierten heißen Ladungsträger im Halbleiter 2 Potentialverhältnisse vor, die eine kräftige Beschleunigung und damit eine Drift zu den gegenüberliegenden Elektrode 3, 4 im wesentlichen ausschließen. Statt dessen erfolgt eine Relaxation der Ladungsträger durch Stöße an optischen Photonen, und diese Relaxation induziert einen schnell abklingenden Verschiebungsstrom an den beiden Elektroden.

Dieses Verhalten ist in Figur 3 dargestellt, wo φ die Schottky-Barrierenhöhe, E_{F} die jeweilige Fermienergie im Metall 3 und 4 und E_{L} bzw. E_{V} die Energieniveaus des Leitungs- und des Valenzbandes des Halbleiters 2 bezeichnen. In der Figur 3 ist insbesondere auch erkennbar, daß die Schottky-Barrieren unsymmetrisch gewählt sind. Hierdurch kann man erreichen, daß sowohl für Löcher als auch für Elektronen der Relaxationsprozeß das optische Signal dominiert, so daß beide Arten von Ladungsträgern nicht bis zur gegenüberliegenden Elektrode driften.

Die erfindungsgemäße Ladungsträgerdynamik im Halbleiter bewirkt, daß die beobachteten Signale deutlich schneller als bei einer MSM-Photodiode in konventioneller Betriebsart sind, und zwar selbst bei sehr kleinen Elektrodenabständen. Der generierte Verschiebungsstrom ergibt nach dem Schottky-Ramos-Theorem einen bipolaren Puls, wobei allerdings die erste ansteigende und abfallende Flanke, bedingt durch den Relaxationsprozeß, wesentlich schneller verläuft als der Diffusionsprozeß zurück zur Ausgangselektrode.

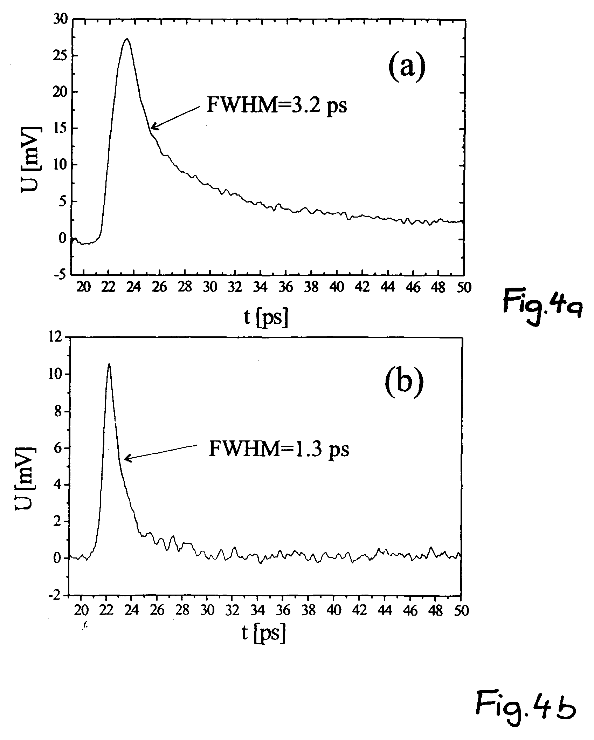

Zum Vergleich der erreichbaren Pulsgeschwindigkeiten sind in den Figuren 4a und 4b Pulse aus derselben Schottky-Diode dargestellt, wobei Figur 5a das Verhalten für den Fall darstellt, daß die Diode in herkömmlicher Weise unter Ausnutzung der Ladungsträgerdrift betrieben wurde, wobei eine Spannung angelegt war, die eine Ladungsträgerdrift mit Sättigungsgeschwindigkeit bewirkte, während die Figur 4b den erfindungsgemäßen Betriebsmodus zeigt, in dem die angelegte Spannung nahezu zum Flachbandfall reduziert war und die Dynamik ausschließlich auf die Relaxation der durch inneren Photoeffekt in den Halbleiter emittiertenheißen Ladungsträger zurückzuführen ist. Aus dem Vergleich der beiden Darstellungen wird deutlich, daß unter Anwendung des erfindungsgemäßen Verfahrens ein dreimal schnellerer Puls gemessen wurde als bei Anwendung des herkömmlichen Verfahrens.

## Patentansprüche

1. Verfahren zur Umwandlung von Lichtpulsen in elektrische Signale mittels einer Metall-Halbleiter-Metall-Photodiode (1), bei dem die Photodiode (1) mit Lichtpulsen beleuchtet wird und die Lichtpulse von der Photodiode (1) in elektrische Signale umgesetzt werden, **dadurch gekennzeichnet**, daß die Photodiode (1) mit Lichtpulsen von einer solchen Wellenlänge beleuchtet wird, daß heiße Ladungsträger aus einer Metallschicht (3) der Photodiode (1) in den Halbleiter (2) emittiert werden und in dem Halbleiter (2) relaxieren, wobei die Relaxation einen Verschiebungsstrom induziert, der sich als elektrischer Puls manifestiert.

2. Verfahren nach Anspruch 1, **dadurch gekennzeichnet**, daß eine Photodiode (1) mit mindestens einem Schottkykontakt zwischen dem Halbleiter (2) und einer Metallschicht (3) verwendet wird und die Wellenlänge der Lichtpulse so gewählt wird, daß die Energiequanten hν der Photonen größer als der Wert der Schottky-Barriere φ, aber kleiner als die Bandlückenenergie des Halbleiters (2) ist.

3. Verfahren nach Anspruch 2, **dadurch gekennzeichnet**, daß ein Silizium-Halbleiter mit einer Bandlücke von etwa 1,1 eV verwendet wird und die Längenwelle der Lichtpulse so gewählt wird, daß die Quantenenergie der Photonen größer als 0,3 bis 0,7 eV und kleiner als 1,1 eV ist.

4. Verfahren nach Anspruch 2 oder 3, **dadurch gekennzeichnet**, daß die Metallschichten (3, 4) mit dem Halbleiter (2) jeweils eine Schottky-Barriere bilden, wobei die Schottky-Barriere an dem ersten Schottkykontakt für Löcher geringer ist als die Barriere für Elektronen und an dem zweiten Schottkykontakt die Schottky-Barriere für Elektronen geringer ist als die für Löcher.

5. Verfahren nach einem der Ansprüche 2 bis 4**, dadurch gekennzeichnet**, daß an der Photodiode (1) eine Spannung angelegt wird, die einem Driften von Ladungsträgern zwischen den Metallschichten (3, 4) entgegenwirkt.
